# EUROPEAN PATENT SPECIFICATION

(11) **EP 2 662 891 B1**
(45) Date of publication and mention of the grant of the patent: **29.04.2020**
(21) Application number: 12003605.8
(22) Date of filing: 07.05.2012
(51) Int. Cl.: H01L 23/49, C22F 1/04, C22F 1/08, B32B 15/01, C22C 9/00, C22C 21/00, H01B 1/02, B23K 1/00

(54) **Method for making an aluminium coated copper bond wire**
Verfahren zur Herstellung eines aluminiumbeschichteten Kupferbonddrahtes
Méthode de production d'un fil de connexion en cuivre revêtu d'aluminium

(43) Date of publication of application: 13.11.2013
(73) Proprietor: Heraeus Deutschland GmbH & Co. KG, 63450 Hanau (DE)
(72) Inventor: Milke, Eugen, Dr., 60322 Frankfurt (DE); Prenosil, Peter, 63477 Maintal (DE); Thomas, Sven, Dr., 63128 Dietzenbach (DE)
(74) Representative: Herzog IP Patentanwalts GmbH

(56) References cited:
- DE-A1-102010 031 993
- DE-B3-102006 023 167
- US-A1- 2004 014 266
- "Excerpt. PHENOMENES DE TRANSPORT. Deuxième Partie ED - ABLITZER D; COMBEAU H", 1 January 1996 (1996-01-01), PHENOMENES DE TRANSPORT. DEUXIÈME PARTIE, EEIGM, PAGE(S) 83 - 174, XP001525460,

## Description

The invention relates to a process for making a wire.

Bonding wires are used in the manufacture of semiconductor devices for electrically interconnecting an integrated circuit and a printed circuit board during semiconductor device fabrication. Further, bonding wires are used in power electronic applications to electrically connect transistors, diodes and the like with pads or pins of the housing. While bonding wires were made from gold in the beginning, nowadays less expensive materials are used such as copper or aluminium. While copper wire provides very good electric and thermal conductivity, wedge-bonding of copper wire has its challenges compared to wires made of aluminium. Moreover, copper wires are susceptible to oxidation of the wire.

With respect to wire geometry, most common are bonding wires of circular cross-section and bonding ribbons which have a more or less rectangular cross-section. Both types of wire geometries have their advantages making them useful for specific applications. Thus, both types of geometry have their share in the market. For example, bonding ribbons have a larger contact area for a given cross-sectional area. However, bending of the ribbons is limited and orientation of the ribbon must be observed when bonding in order to arrive at acceptable electrical contact between the ribbon and the element to which it is bonded. Turning to bonding wires, these are more flexible to bending. However, bonding involves either soldering or larger deformation of the wire in the bonding process, which may cause harm or even destroy the bonding pad and underlying electric stuctures of the element, which is bonded thereto.

Some recent developments were directed to bonding wires having a core and a shell, which is, e.g., a coating layer. As core material, copper or gold may be chosen because of high electric conductivity. With regard to the coating layer, aluminium is one of the more common choices.

DE 10 2006 023167 B3 discloses an aluminium coated copper bond wire, wherein the copper core has a diameter of 60 to 100 µm and the aluminium coating has a thickness of 200 nm to 10 µm. US 2004/014266 A1 discloses an aluminium coated copper bond wire, wherein an intermetallic phase is formed between the aluminium coating and the copper core during a continuous heat treatment between 300°C-900°C in a tubular oven.

These core-shell bonding wires combine some of the advantages of the copper wire and some of the aluminium wire. Recent achievements make using standard wedge-bonding processes for such aluminium coated copper wires possible. Nevertheless, there is an ongoing need for further improving bonding wire technology with regard to the bonding wire itself and the bonding processes.

Accordingly, it is an object of the invention to provide improved wires.

Thus, it is another object of the invention to provide wire, which has good processing properties and which has no specific needs when interconnecting, thus saving costs.

It is also an object of the invention to provide wire which has excellent electrical and thermal conductivity.

It is a further object of the invention to provide wire which exhibits an improved reliability.

It is a further object of the invention to provide wire which exhibits excellent bondability.

It is another object of the invention to provide wire which has improved resistance to corrosion and/or oxidation.

It is another object to provide a novel wire to be used with standard chip and bonding technology which novel wire assures extended lifetime over conventional wires.

It is a further object to provide improved electrical devices, in particular for power electronics, which have an extended lifetime compared to conventional devices in which the electrical elements are interconnected by standard aluminium wires.

It is another object to provide improved electrical devices, in particular for power electronics, which operate at higher electrical current flow than conventional devices in which bonding is based on aluminium wires.

It is another object of the invention to provide such improved electrical devices which have the same dimensions and similar chip design as aforementioned conventional devices. It is another object to provide means for manufacturing such improved electrical devices on production lines originally designed for the manufacture of conventional electrical devices. This would minimize cost for implementing the improved technology.

It is a further object to provide improved electrical devices in which the probability of unintended internal electrical bridging is reduced compared to conventional electrical devices. Further, it is an object to simplify, or even to be able to omit, particular precautions with regard to unintended internal bridging in electrical devices.

Surprisingly, wires of the present invention have been found to solve at least one of the objects mentioned above. Further, a process for manufacturing these wires has been found which overcomes at least one of the challenges of manufacturing wires. Further, semiconductors comprising the wires of the invention were found to be more reliable at the interface between the wire according to the invention and other electrical elements, e.g., the printed circuit board, the pad/pin etc.

A contribution to the solution of at least one of the above objects is provided by the subject matters of the category-forming claims, whereby the dependent sub-claims of the category-forming independent claims representing preferred aspects of the invention, the subject matter of which likewise makes a contribution to solving at least one of the objects mentioned above.

A first aspect of the disclosure is a wire comprising:
a. a copper core with a surface; and
b. a coating layer superimposed over the surface of the copper core,
   wherein the coating layer comprises aluminium,
wherein in a cross-sectional view of the wire the area share of the coating layer is in the range of from 10 to 60 %, preferably from 20 to 50 %, or 25 to 45 %, or 30 to 40 %, each based on the total area of the cross-section of the wire, and
wherein the aspect ratio between the longest path and the shortest path through the wire in a cross-sectional view is in the range of from larger than 0.8 to 1.0, preferably from 0.9 to 1.0, or from 0.9 to 0.99, or from 0.95 to 0.99, wherein the wire has a diameter in the range of from 100 µm to 600 µm, preferably in the range of from 150 µm to 550 µm, or from 230 µm to 500 µm.

The wire is preferably a bonding wire for bonding in microelectronics. The wire is preferably a one-piece object. The criteria for aforementioned cross-sectional view and the diameter should be met within at least 80 %, preferably 90 % of the longitudinal extension of the wire.

The term "a cross-sectional view" in the present context refers to a view of a cut through the wire, wherein the plane of the cut is perpendicular to the longitudinal extension of the wire. The cross-sectional view can be found at any position on the longitudinal extension of the wire

The "longest path" through the wire in a cross-section is the longest chord which can be laid through the cross-section of the wire within the plane of the cross-sectional view.

The "shortest path" through the wire in a cross-section is the longest chord perpendicular to the longest path within the plane of the cross-sectional view defined above.

If the wire has a perfect circular cross-section, then the longest path and the shortest path become indistinguishable and share the same value.

The term "diameter" is the arithmetic mean of all geometric diameters of any plane and in any direction, wherein all planes are perpendicular to the longitudinal extension of the wire.

The term "superimposed" in the context of this invention is used to describe the relative position of a first item, e.g. a copper core, with respect to a second item, e.g. a coating layer. Possibly, further items, may be arranged between the first and the second item. Preferably, the second item is at least partially superimposed over the first item, e.g. for at least 30 %, 50 %, 70 % or for at least 90 % with respect to the total surface of the first item.

The term "thickness" in the context of this invention is used to define the size of a layer in perpendicular direction to the longitudinal axis of the copper core, which layer is at least partially superimposed over the surface copper core.

The term "intermediate layer" in the context of this invention is a region of the wire, between the copper core and the coating layer. In this region, material as in the core as well as material as in the coating layer is present in combination, for example, in form of at least one intermetallic phase.

The term "intermetallic phase" in the context of this invention is used to define a phase of two or more metals, wherein the different elements are ordered into different sites in the structure, which sites have distinct local environments and often a well-defined, fixed stoichiometry. This is a difference with regard to alloys, in which the different elements are randomly distributed.

All of aforementioned dimensions of length, e.g. thickness, diameter, longest path, shortest path are determined in a cross-sectional view as defined above.
The "surface" of the copper core of a uncoated copper wire is the wire/air interface.

The "surface" of the copper core of a coated, annealed wire is defined to be the virtual limit of the copper core around its center, which virtual limit is where the concentration of Cu deviates more than 9.9 %-wt. from the concentration of Cu at the center of the wire, which center is defined by the intersection of the shortest and the longest path both as defined above. Preferably, the wire of the invention has a substantially circular area in a cross-sectional view of the wire.

The copper core according to the invention comprises at least 95 % by weight, preferably at least 98 % by weight, each based on the total weight of the copper core, of elemental copper (Cu) of a purity of at least 99.9 % Cu. Preferably, the purity of the copper core is at least 99.99 %, or 99.999 %, or 99.9999 %.

The coating layer comprising aluminium is preferably selected from the group consisting of aluminium, aluminium alloys or a combination of the two.

Preferred aluminium is elemental aluminium (Al) of a purity of at least 99.9 % Al, more preferable, the purity of aluminium is at least 99.99 % Al, or 99.999 % Al. Usually, such coating layers form a thin layer of aluminium oxide at the aluminium-air interface.

Preferably, the coating layer comprises at least 80 % by weight, preferably at least 90 % by weight, each based on the total weight of the coating layer, of aluminium of a purity of 99.9 %, yet more preferable of a purity of 99.99 %.

Preferred examples of aluminium alloys are alloys with magnesium (AlMg) and alloys of aluminium with 1 %-wt. of silicon (AlSi1), based on the total amount of the alloy.

According to another aspect, the diameter of the copper core is in the range of from 70 to 500 µm, preferably from 150 to 400 µm, or from 200 to 300 µm, or from 230 to 250 µm, each determined in a cross-sectional view of the wire.

According to another aspect, the ratio of the standard deviation of the diameter of the copper core and the diameter of the copper core is less than 0.1, preferably less than 0.05, or less than 0.03, or from 0.03 to 0.001.

According to another aspect, the thickness of the coating layer is in the range of from 10 to 60 µm, preferably from 20 to 50 µm, preferably from 20 to 40 µm, or from 25 to 35 µm, each determined in a cross-sectional view of the wire. The aforementioned criteria for thickness of the coating layer should be met within at least 80 %, preferably 90 % of the longitudinal extension of the wire.

According to another aspect, the ratio of the standard deviation of the thickness of the coating layer and the thickness of the coating layer is in the range of from 0.05 to 0.5, preferably from 0.1 to 0.3.

An intermediate layer is arranged between the core and the coating layer. The intermediate layer preferably comprises at least one intermetallic phase comprising material of the core and material of the coating layer. The intermediate layer usually shows concentration gradients for each of the materials involved. An intermetallic phase is formed if both materials are metals.

The intermediate layer is arranged between the core and the coating layer, wherein the intermediate layer is adjacent to the copper core and adjacent to the coating layer.

The intermediate layer of the wire is defined to be the region of the wire between the copper core and the coating layer in which the concentration of Cu deviates more than 5 %-wt., based on the total weight of the intermediate layer, from the concentration of Cu in the copper core, based on the total weight of the copper core, and in which the concentration of Al deviates more than 5 %- wt., based on the total weight of the intermediate layer, from the concentration of Al in the coating layer, based on the total weight of the coating layer.

Aforementioned dimensions, i.e. the thickness of the coating layer, the thickness of the intermediate layer and the diameter of the copper core can be determined in a cross-sectional view of the wire, e.g. using light microscopy or scanning electron microscopy. In light microscopy, the copper core is coloured in copper red, the coating layer is silvery and the intermediate layer is grey. The concentrations of copper and aluminium which were described above, can be determined using combined SEM/EDX. (Scanning electron microscopy / energy dispersive X-ray spectroscopy).

According to another aspect, the area share of the intermediate layer in any cross-sectional view of the wire is in the range of from 0.4 to 15 %, preferably from 0.8 to 8.5 %, each based on the total area of the cross-section of the wire.

According to another aspect, the thickness of the intermediate layer is in the range of from 0.1 to 5 µm, preferably from 0.5 to 3 µm. The aforementioned criteria for thickness of the intermediate layer should be met within at least 80 %, preferably 90 % of the longitudinal extension of the wire. Sometimes, deviations in the thickness of the intermediate layer may occur due to imperfections of the intermediate layer, e.g. pores.

According to another aspect, the standard deviation of the thickness of the intermediate layer is in the range of from 0.1 to 5 µm, preferably from 0.4 to 4 µm, or from 0.5 to 3 µm.

According to another aspect, the dissipated work is at least 2, preferably at least 3 times as high for a wire according to the disclosure than the dissipated work for a reference wire made from pure Al. Preferably the dissipated work is at least 2, preferably at least 3 times as high a the wire according to the disclosure than the dissipated work for a reference wire made from pure Al in a testing cycle in the range of from 20000 to 120000 testing cycles. More preferably the dissipated work is at least 2, preferably at least 3 times as high for a wire according to the disclosure than the dissipated work for a reference wire made from pure Al in all testing cycles in the range of from 20000 to 120000 testing cycles. In some cases, however, the dissipated work is not more than 10 times as high as for a wire according to the disclosure than the dissipated work of a reference wire made from pure Al. This reference wire is an aluminium wire made from aluminium of a purity of 99.999 % which is doted with 50 ppm nickel (sold by Heraeus/Germany under "AL-H11 CR") and which has the same cross-sectional area as the wire of the disclosure.

According to another aspect, the maximum strain is at least 1.5, preferably at least 2 times as high for a wire according to the disclosure than the maximum strain for a reference wire made from pure Al. Preferably, the maximum strain is at least 1.5, preferably at least 2 times as high for a wire according to the disclosure than the maximum strain from a reference wire made from pure Al in a testing cycle in the range of from 20000 to 120000 testing cycles. More preferably, the maximum strain is at least 1.5, preferably at least 2 times as high for a wire according to the disclosure than the maximum strain for a reference wire made from pure Al in all testing cycles in the range of from 20000 to 120000 testing cycles. In some cases, however, the maximum strain is not more than 10 times as high than the maximum strain of a reference wire made from pure Al. This reference wire is an aluminium wire made from aluminium of a purity of 99.999 % which is doted with 50 ppm nickel (sold by Heraeus/Germany under "AL-H11 CR") and which has the same cross-sectional area as the wire of the disclosure.

According to another aspect the number of cycles under same conditions in the power cycling test is at least 3, preferably at least 4 times as high for a wire according to the disclosure than the power cycling test for a reference wire made from pure Al in a testing cycle in the range of from 20000 to 120000 testing cycles. More preferably, the number of cycles under same conditions in the power cycling test is at least 3, preferably at least 4 times as high for a wire according to the disclosure than the power cycling test for a reference wire made from pure Al in all testing cycles in the range of from 20000 to 120000 testing cycles. In some cases, however, the number of cycles under same conditions in the power cycling test is not more than 50 times as high for a wire according to the disclosure than the dissipated work of a reference wire made from pure Al. This reference wire is an aluminium wire made from aluminium of a purity of 99.999 % which is doted with 50 ppm nickel (sold by Heraeus/Germany under "AL-H11 CR") and which has the same cross-sectional area as the wire of the disclosure.

According to another aspect, the wire bond shear of the wire (1) is at least as high for the wire (1) as for a reference wire made from pure Al. This test is described below. This reference wire is an aluminium wire made from aluminium of a purity of 99.999 % which is doted with 50 ppm nickel (sold by Heraeus/Germany under "AL-H11 CR") and which has the same cross-sectional area as the wire of the disclosure.

According to another aspect, the wire pull of the wire (1) is at least 10 % higher, preferably at least 20 % higher for the wire (1) than for a reference wire made from pure Al. This reference wire is an aluminium wire made from aluminium of a purity of 99.999 % which is doted with 50 ppm nickel (sold by Heraeus/Germany under "AL-H11 CR") and which has the same cross-sectional area as the wire of the disclosure.

According to another aspect, the wire of this disclosure meets at least two or even all of the aforementioned test conditions, i.e. dissipated work, maximum strain, power cycling test, wire bond shear and wedge pull.

The invention is a process for manufacturing a wire, comprising at least the following steps:
a. providing a wire precursor comprising a copper core with a surface and a coating layer, which coating layer is superimposed over the surface of the copper core, wherein the coating layer comprises aluminium,
   wherein in a cross-sectional view of the wire precursor the area share of the coating layer is in the range of from 20 to 50 %, based on the total area of the cross-section of the wire precursor, and
   wherein the aspect ratio between the longest path and the shortest path through the wire precursor in a cross-sectional view is in the range of from larger than 0.8 to 1.0,
   wherein the wire precursor has a diameter in the range of from 0.5 to 5 mm, preferably of from 0.75 to 3 mm, or from 0.75 to 2 mm,
b. shaping the wire precursor,
c. annealing the shaped wire precursor,
   whereby the wire is obtained wherein the wire has a diameter in the range of from 100µm to 600 µm, wherein the annealing is performed at a temperature in the range of from 140 °C to 400 °C over a period of from 30 minutes to 5 hours, wherein an intermediate layer is formed in step c.

The wire perferably has a diameter in the range of from 150 to 550 µm, or from 230 to 500 µm.

A wire precursor as in step a. can be obtained by forming an aluminium coating layer on at least part of the surface of the copper wire. Preferably the aluminium layer is formed on 100 %, or from 80 to 100 %, or from 60 to 80 %, of the surface of the copper wire, each with respect to the total surface area of the copper wire. Numerous techniques for forming an aluminium layer on a copper surface and in particular on copper wire are known. Preferred techniques are plating, such as electroplating and electroless plating, deposition of aluminium from the gas phase such as sputtering, ion plating, vacuum evaporation and chemical vapor deposition, and deposition of aluminium from the melt.

Numerous techniques are known to shape the wire precursor. Preferred techniques are rolling, swagging, die drawing or the like, of which die drawing is particularly preferred. More preferably, the wire precursor is drawn in 3 to 20 steps, wherein in each step an elongation of the wire precursor of from 6 to 18 % in length is performed. A slipping agent may be employed. Suitable slipping agents are numerous and known to the skilled person.

Numerous procedures are known in the art to anneal a wire, e.g. annealing of wire can be performed in both, a continuous or in a discontinuous process. In special applications, continuous and discontinuous processes may even be combined.

According to the invention, the annealing is performed by heating the wire precursor to a temperature in the range of from 140 to 400 °C, preferably from 160 to 350 °C, or from 200 to 300 °C, or from 220 to 280 °C and the temperature is maintained for 30 minutes to 5 hours, preferably from 30 minutes to 3 hours. Then, the wire obtained by annealing the wire precursor is cooled to room temperature. The cooling can be performed in various ways. One suitable way is to expose the wire to ambient air at ambient temperature upon leaving the heating zone. The cooling of the wire to room temperature (T = 20 °C) according to aforementioned procedure can be usually achieved within 24 hours. A quenching of the wire should be avoided, e.g. by immersion in cold water and the like. Accordingly, another aspect is a process in which the cooling of the wire upon leaving the heating zone is not performed by quenching of the wire. According to another aspect of the invention, the annealing in a tube furnace may be performed in an inert atmosphere or a reducing atmosphere. This applies, in particular, to annealing in a discontinuous process. Numerous inert atmosphere as well as reducing atmospheres are known in the art. Of the known inert atmospheres, nitrogen is preferred. Of the known reducing atmospheres, the hydrogen is preferred. Further, preferred reducing atmospheres are mixtures of nitrogen and hydrogen. Preferably, mixtures of nitrogen and hydrogen are preferred which are in the range of from 90 to 98 %-Vol. nitrogen and of from 10 to 2 Vol-% hydrogen, each referring to the total volume of the mixture. Preferred mixtures of nitrogen/hydrogen are equal to 93/7, 95/5 and 97/3 Vol-%/Vol-%, each based on the total volume of the mixture. Applying reducing atmospheres in annealing is particularly preferred, if some parts of the surface of the wire are sensitive to oxidation by oxygen of the air, e.g. if copper of the wire is exposed to its surface.

According to the invention, an intermediate layer is formed during annealing.

Another aspect is a wire obtainable by a process defined above.

According to another aspect, the wire is characterized by at least one of the following features:
a. the dissipated work is at least 2 times as high for the wire according to the disclosure than the dissipated work for a reference wire made from pure Al;
b. the maximum strain in a uniaxial cyclic test is at least 2 times as high for the wire according to the disclosure than the maximum strain for a reference wire made from pure Al;
c. the number of cycles under same conditions in the power cycling test is at least 3 times as high for the wire according to the disclosure than for a reference wire made from pure Al;
d. the wire bond shear of the wire according to the disclosure is as high for the wire according to the disclosure as for a reference wire made from pure Al;
e. the wire pull of the wire according to the disclosure is at least at least 10 %, preferably at least 20 % higher for the wire according to the disclosure than for a reference wire made from pure Al.
f. the electrical conductivity of the wire according to the disclosure is in the range of from 20 % to 55 % higher than the electrical conductivity of a reference wire made from pure Al.

The reference wire made from pure Al mentioned above is an aluminium wire made from aluminium of a purity of 99.999 % which is doted with 50 ppm nickel (sold by Heraeus/Germany under "AL-H11 CR") and which has the same cross-sectional area as the wire of the disclosure.

Another aspect is an electric device comprising two elements and at least a wire as defined above or a wire manufactured as described above.

According to another aspect, at least one wire in the electric device is connected to another element of the electric device by wedge bonding, preferably by ultrasonic wedge wedge bonding.

According to another aspect, at least one of the elements is selected from the group consisting of a substrate, an IGBT (i.e.: a insulated gate bipolar transistor), an integrated circuit, a transistor, a diode, such as a light emitting diode, a photo diode.

Another aspect is a use of the wire described above or of wire manufactured according to a process as described above in wedge-wedge bonding interconnections between a control unit and a controlled device.

Another aspect is a propelled device, preferably a propelled vehicle, a solar cell or a wind turbine, which propelled device comprises at least one electric device as described above.

Another aspect is a process for making an electric device comprising the steps of
a. providing at least two elements;
b. connecting the two elements through a wire as described above, wherein at least one of said connections is performed by wedge bonding.

Wedge bonding technology is known in the art and extensively described in the literature, e.g. in Shankara K. Prasad, "Advanced Wirebond Interconnection Technology", Kluwer Academic Publishers, 2004, ISBN 1-4020-7762-9, in particular chapter I (introduction) and chapter IV (process technology).

### DESCRIPTION OF THE FIGURES

In Figure 1, a wire 1 is depicted.

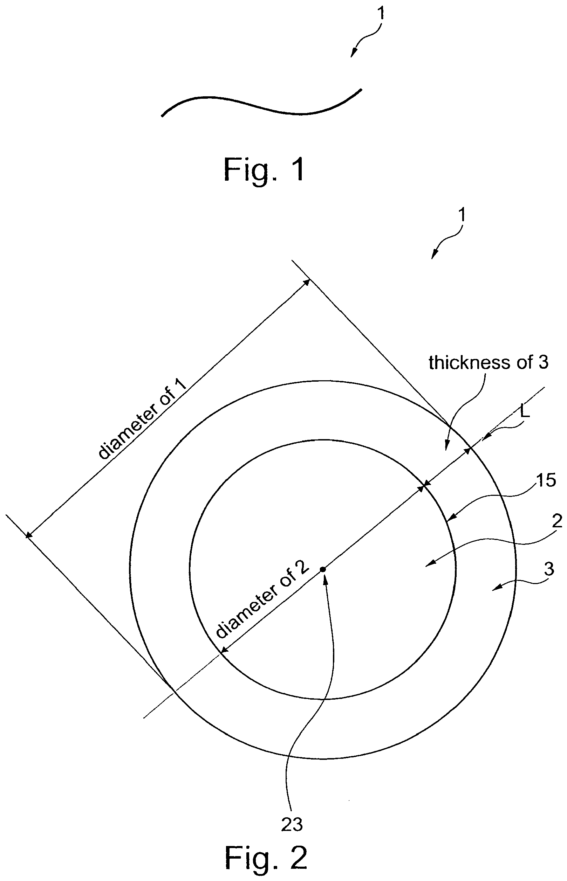

Figure 2 shows a cross sectional view of wire 1. In the cross sectional view, a copper core 2 is in the middle of the cross sectional view. The copper core 2 is encompassed by a coating layer 3. On the limit of copper wire 2, a surface 15 of the copper core is located. On a line L through the center 23 of wire 1 the diameter of copper core 2 is shown as the end to end distance between the intersections of line L with the surface 15. The diameter of wire 1 is the end-to-end distance between the intersections of line L through the center 23 and the outer limit of wire 1. Besides, the thickness of coating layer 3 is depicted.

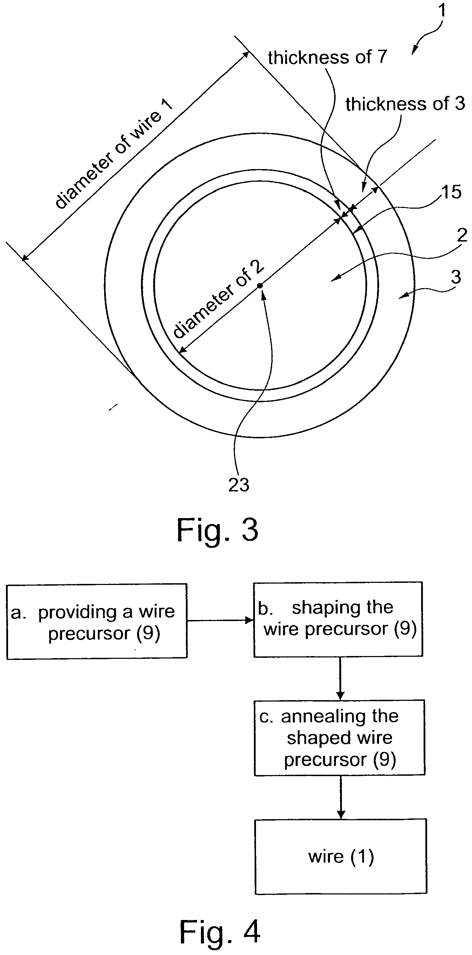

In Figure 3, a wire 1 having a copper core 2, an intermediate layer 7 and a coating layer 3 is depicted. In addition to the items described for Figure 2, the thickness of the intermediate layer 7 is shown.
Figure 4 shows a process according to the invention.

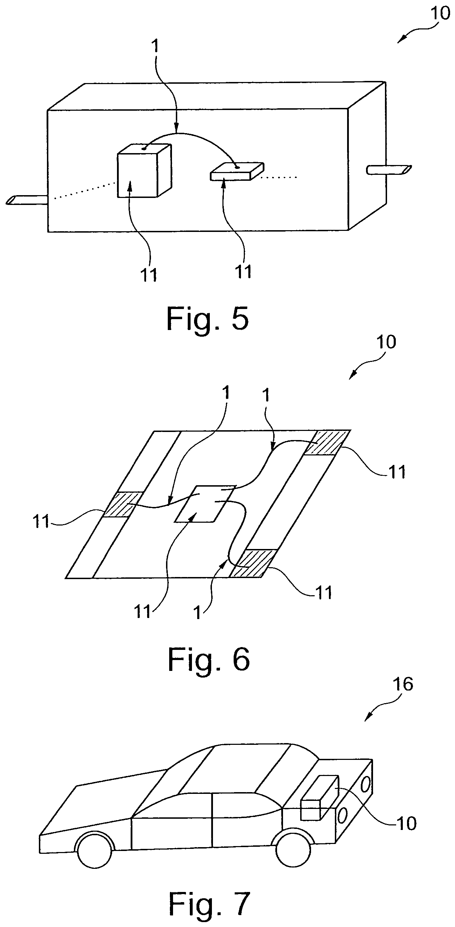

Figure 5 depicts an electric device comprising two elements 11 and a wire 1. The wire 1 electrical connects the two elements 11.
Figure 6 depicts another electric device 10. Four elements 11 are electrically connected by three wires 1.
Figure 7 depicts a propelled device 16, in this case a car, which comprises an electric device 10.

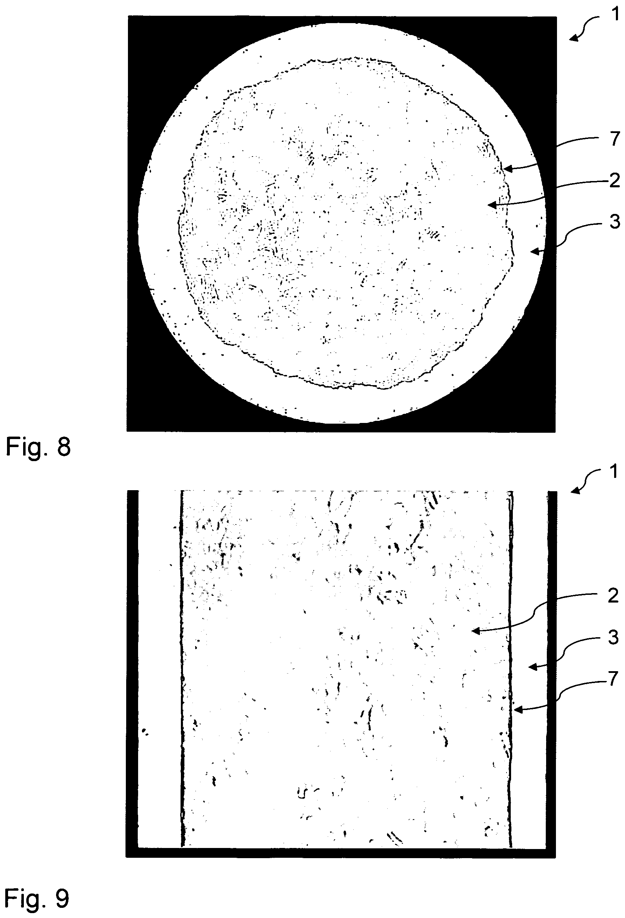

In Figure 8 a cross sectional view of a piece of wire according to the disclosure is shown.
In Figure 9, a longitudinal cut through a piece of wire according to the disclosure is shown.

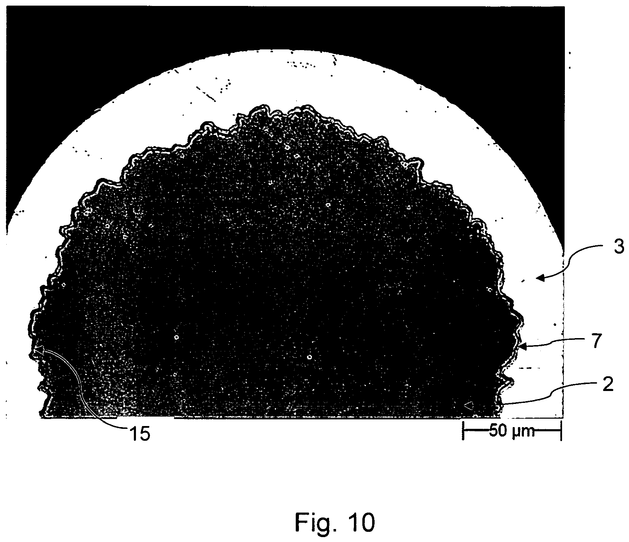

Figure 10 depicts a magnification of a wire 1. From bottom to top is shown a section of a copper core 2 followed by an intermediate layer 7, between both the surface of the copper core 15. On top of the intermediate layer 7 is a coating layer 3. The black area on top, which is adjacent to coating layer 3, is background and not part of the example.

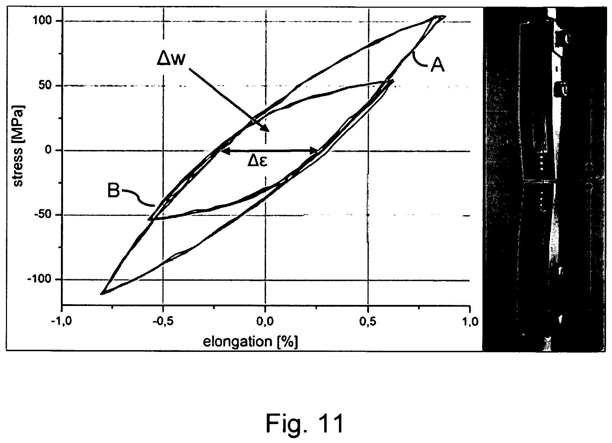

Figure 11 depicts an exemplifying chart of the strain-uniaxial cyclic test. On x axis, the elongation is shown in %. On y axis, stress [MPa] is shown. The resulting curve from the experiment is a historesis loop. The curve marked with A was recorded by a wire according to the disclosure, curve B was recorded with a reference wire made from pure aluminium. Δεₚₗ and Δ*w* are determined as described in the test method.

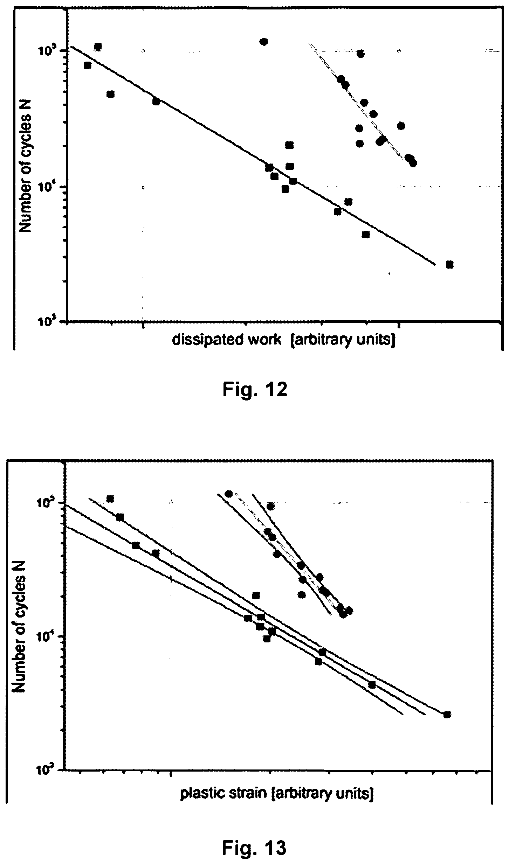

Figure 12 and Figure 13 show a plurality of measurements as described for Figure 11 collecting the resulting for dissipated work in a chart in Figure 12 and for plastic strain in Figure 13. Values marked with round dots were recorded by a wire according to the disclosure, values marked with rectangular dots was recorded with a reference wire made from pure aluminium.

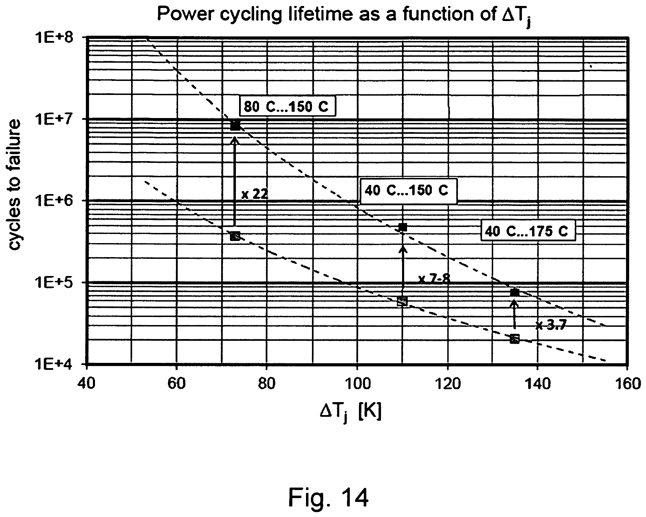

Figure 14 shows a chart collecting the results of power cycling tests. On the x axis the ΔT, which is the difference between the temperature at start of a cycle and at stop of a cycle is shown. On y axis the number of cycles until failure is shown. In this chart, a curve for a sample of pure aluminum is shown (curve fit through light rectangular dots). Further, a curve for wire according to the disclosure is shown (curve fit through dark rectangular dots). According to the chart the number of cycles to failure is for the wire of the disclosure at least three times as high as for a reference of pure aluminum.

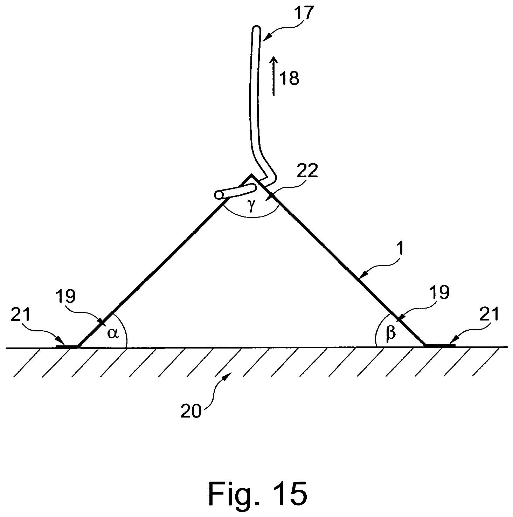

Figure 15 shows a sketch of a wire pull test. To a substrate 20, a wire 1 is bonded in bonds 21 at an angle 19 of 45°. A pull hook 17 pulls wire 1. The angle 32, which is formed when the pull hook 17 pulls wire 1, is 90°C.

### TEST METHODS

All tests and measurements were conducted at T = 20 °C and a relative humidity of 50 %.

### ELECTRICAL CONDUCTIVITY

Both ends of a test specimen, i.e. a wire of 1.0 m in length, were connected to a power source providing a constant current of I = 10 mA. The voltage was recorded with a device for measuring voltage. This set-up was repeated with at least 4 test specimens. The arithmetic mean of the four measurements was used for the calculations given below.

The resistance R was calculated according to R = U / I.

The specific resistivity ρ was calculated according to ρ = (R x A) / 1, wherein A is the mean cross-sectional area of the wire and 1 the length of the wire between the two measuring points of the device for measuring voltage.

The specific conductivity σ was calculated according to σ = 1 / ρ.

### LAYER THICKNESS

For determining the thickness of the coating layer, the thickness of the intermediate layer and the diameter of the core, the wire was cut perpendicular to the maximum elongation of the wire. The cut was carefully grinded and polished to avoid smearing of soft materials, e.g. Al. A picture was recorded through an optical microscope or a scanning electron microscope (SEM), wherein the magnification is chosen so that the full cross-section of the wire is shown.

This procedure was repeated at least 15 times. All values are provided as arithmetic mean of the at least 15 measurements.

### WEDGE-WEDGE BONDING - PARAMETER DEFINITION

Bonding of a wire to a substrate made of CuSn6 plated with AlSi1 (available from Heraeus/Germany) was performed at 20°C, wherein the bonding was applied to the AlSi1 surface. After forming a first wedge bond with an angle of 45° between the wire and the substrate, the wire was wedged with its second end to the substrate. The distance of the bonds between the two ends of the wire was in the range of from 5 to 20 mm. This distance was selected in order to assure the angle of 45° between the wire and the substrate. During wedge bonding, ultrasonic sound of a frequency in the range of 60 - 120 kHz was applied to the bondtool for 40 to 500 milliseconds.

Then, reference samples of standard wire made from aluminium ALH11-CR were wedge bonded as described above. The extent of wire deformation of the bonded wire was evaluated by determining the area of the contact of the wire on the substrate (A_{c ref}).

Regarding the samples to be tested which are made using a wire according to the disclosure, the wedge bonding parameters, i.e. applied force, frequency and time of exposure to ultrasonic sound, must be adapted to achieve an area of contact of the wire according to the disclosure on the substrate (A_{c inv}), wherein A_{c ref} equals A_{c inv}. With regard to copper wire having a coating layer comprising aluminium, the applied energy must be increased, i.e. one of the parameters: applied force, frequency of ultrasonic sound and length of exposure to ultrasonic sound must be increased.

### WIRE PULL

Wire pull tests were conducted according to MIL-STD-883G Method 2011.7 (1989), Condition D on a XYZTEC Condor 150 machine. The wire was bonded onto an aluminium substrate made of CuSn6 plated with AlSi1 (available from Heraeus/Germany) at an angle of 45°, wherein the bonding was applied to the AlSi1 surface. The distance of the bonds between the two ends of the wire were in the range of from 5 to 20 mm. This distance was selected in order to assure the angle of 45° between the wire and the substrate. The loop was pulled in the middle of the loop at a pull speed of 2500 µm/s, The diameter of the pull hook was at least twice the diameter of the wire.

### WIRE BOND SHEAR TEST

Wire bond shear tests were conducted according to AEC-Q101-003 Rev-A (07.2005) on a XYZTEC Condor 150 machine. The wire was bonded to an aluminium substrate made of CuSn6 plated with AlSi1 (available from Heraeus/Germany) at an angle of 45°, wherein the bonding was applied to the AlSi1 surface. Then, the shear tool was lowered to the substrate at a speed of 50 µm/s to define zero height. Next, the shear tool was retracted from the substrate to a distance of 10 % of the diameter of the bonded wire. Then, shearing was conducted at a rate of 250 µm/s. The bond shear failure mode was also recorded: (1) bond lifting; (2) bond shearing; (3) cratering; (4) bonding surface lifting (separation of the bonding surface from its underlying substrate).

### STRAIN AND DISSIPATED WORK- UNIAXIAL CYCLIC TEST

A sample of straight wire was clamped in a machine to apply mechanical strain (tension and compression). The length of wire exposed to mechanical testing is 1.0 mm. Cycling of the sample was performed at a strain rate of 1 %/s until failure of the sample (breakage of wire). The machine recorded the force transmitted by the sample. The plastic strain amplitude (Δεₚₗ) and the dissipated work (Δ*w*) are each plotted versus number of cycles (N) until failure.

Δεₚₗ is defined as strain difference at zero stress of increasing and decreasing branches of hysteresis loop.

Δ*w* is defined as the integral of one hysteresis loop.

### POWER CYCLING TEST

Samples were produced by wedge bonding a diode EMCON 4 High Power Chip (available from INFINEON Technologies AG, Munich, Germany) to a base plate using the wire to be tested. As described above, wedge bonding parameters were chosen in a suitable way, assuring that all bonded wires show the same area of contact between the wire and the base plate (A_{c ref}). Of the commercially available base plates, a base plate was chosen that will retain the die attached (the diode) during the test. All samples were prepared using identical base plates.

Power cycling tests were conducted on a ITC5230 supplied from Integrated Technology Corporation, Tempe, AZ85281, USA. For testing, a sample was mounted on a cooling pad through which the sample was permanently cooled at constant flow rate using a fluid having a temperature 20°C at the inlet of the cooling pad. To assure a defined transfer of heat dissipated by the sample, a heat conducting film was arranged between the sample and the cooling pad. The electrodes of ITC5230 were contacted to the diode and to the base plate.

Prior to the power cycling test, the amount of electrical current (I₀) at a preset voltage (V₀) and the time was evaluated which are necessary to effect an increase in temperature to 175 °C of the sample from a starting temperature of 40 °C. This time is the ON-time of a cycle. After that, the cooling time of the sample to cool down from 175 °C to 40 °C was evaluated, while no electrical current was applied to the sample. This time is the OFF-time. A sequence of one ON-time followed by one OFF-time defines one power cycle.

Then, the power cycling test performed by continuously applying aforementioned power cycles. At preset electrical current I₀, the voltage (Vₜ) during ON-time of a power cycle was recorded. The power cycling test was finished, when the voltage Vₜ during an ON-time period exceeded the voltage V_{f}. V_{f} = (V₀ + 10 %).

### EXAMPLES

The invention is further exemplified by examples. These examples serve for exemplary elucidation of the invention and are not intended to limit the scope of the invention or the claims in any way.

### Examples 1 - 12

A wire of overall diameter 1 mm wire having an aluminium coating of thickness 115 µm and a diameter of the copper core 770 µm was elongated using 22 drawing dies, each providing an elongation of 12 % to obtain a wire of the wire diameter detailed in Table 1. Then, the elongated wire was put on a roll and annealed in an oven for 1 hour at the annealing temperature T detailed in Table 1. After the annealing, the wire was cooled to ambient temperature was within 24 hours. The properties of these wires and the processing parameters of the wire treatment are collected in Table 1, the experimental data in Table 2 below.

**Table 1: Physical properties and process parameters**

| Example No. | Annealing Temperature T [°C]¹ | Thickness intermediate layer | | Thickness coating layer | | Cu diameter² | wire diam. | Al [area-%] calculated | Cu [area-%] measured |
|---|---|---|---|---|---|---|---|---|---|
| | | mean [µm] | stddev [µm] | mean [µm] | stddev [µm] | mean [µm] | mean [µm] | | |
| 1 | 180 | 1.944 | 2.345 | 34.113 | 4.484 | 225.5 | 297.6 | 40.6 | 57.4 |
| 2 | 220 | 2.063 | 2.516 | 32.125 | 5.058 | 229.4 | 298.1 | 38.5 | 59.2 |
| 3 | 280 | 1.929 | 2.336 | 30.786 | 4.758 | 232.1 | 297.4 | 37.1 | 60.9 |
| 4 | 360 | 4.714 | 2.164 | 31.786 | 3.906 | 224.7 | 297.6 | 38.2 | 57.0 |
| 5 | 180 | 1.294 | 1.408 | 25.000 | 6.755 | 248.4 | 299.7 | 30.6 | 68.7 |
| 6 | 220 | 1.900 | 1.746 | 26.081 | 5.006 | 244.5 | 300.0 | 31.8 | 66.4 |
| 7 | 280 | 2.394 | 2.989 | 25.519 | 4.665 | 243.3 | 299.1 | 31.2 | 66.2 |
| 8 | 360 | 3.775 | 2.556 | 24.600 | 4.564 | 242.8 | 299.5 | 30.2 | 65.7 |
| 9 | 180 | 0.169 | 0.675 | 27.513 | 3.472 | 245.3 | 300.7 | 33.3 | 66.6 |
| 10 | 220 | 0.131 | 0.525 | 28.119 | 3.675 | 245.2 | 301.7 | 33.8 | 66.1 |
| 11 | 280 | 0.000 | 0.000 | 28.888 | 4.726 | 245.1 | 302.8 | 34.5 | 65.5 |
| 12 | 360 | 2.750 | 0.651 | 28.813 | 2.921 | 238.9 | 302.1 | 34.5 | 62.6 |
| Al-H11CR³ | | | | | | | 300 | 100.0 | 0 |
| Al-H11 | | | | | | | 300 | 100 | 0 |

| | | | | | | | | | |
|---|---|---|---|---|---|---|---|---|---|
| ¹Annealing Time: 1 hour ²diameter of the copper core | | | | | | | | | |

**Table 2**

| Example No. | Specific conductivity [m/Ω *mm2] | Wire pull [cN] | 1st wire bond shear⁴ [cN] | 2nd wire bond shear⁴ [cN] | uniaxial cycling plastic strain 0.25% [Cycles to failure] | uniaxial cycling plastic strain 0.20% [Cycles to failure] | uniaxial cycling plastic strain 0.15% [Cycles to failure] | Power Cycling delta T = 70K [Cycles to failure] | Power Cycling delta T = 135K [Cycles to failure] |
|---|---|---|---|---|---|---|---|---|---|
| 1 | 48.0 | 1394.0 | 1107.4 | 1135.7 | | | | | |
| 2 | 48.2 | 1342.1 | 1270.0 | 1415.9 | | | | | |
| 3 | 48.0 | 1293.1 | 1354.2 | 1472.4 | | | | | |
| 4 | 46.9 | 1038.3 | 1031.1 | 1104.5 | | | | | |
| 5 | 49.2 | 1225.5 | 739.5 | 1042.9 | | | | | |
| 6 | 49.6 | 1309.4 | 1153.0 | 1345.8 | | | | | |
| 7 | 49.3 | 1192.4 | 1223.3 | 1300.4 | | | | | |
| 8 | 48.5 | | | | | | | | |
| 9 | 51.6 | 1559.3 | 1411.5 | 1397.6 | | | | | |
| 10 | 51.5 | 1420.2 | 1480.4 | 1440.5 | | | | | |
| 11 | 51.3 | 1385.8 | 1367.1 | 1465.6 | 27'000 | 53'000 | 118'000 | 8'500'000 | 77'000 |
| 12 | 50.2 | 865.4 | 738.8 | 729.8 | | | | | |
| Al-H11 CR | 37.2 | 955 | 1320 | 1352 | 8'700 | 12'400 | 27'700 | 380'000 | 21'000 |
| Al-H11 | 36.4 | 605.4 | 1237 | 1260.7 | | | | | |

| | | | | | | | | | |
|---|---|---|---|---|---|---|---|---|---|
| ³AlH11-CR and AlH11 are commercial samples of aluminium wire available from Heraeus/Germany ⁴All failures were observed to fail in failure mode (2) - bond shearing. | | | | | | | | | |

### REFERENCE NUMBERS

- (1): wire
- (2): copper core
- (3): coating layer
- (4): contact
- (5): longest path through wire in cross-sectional view
- (6): shortest path through wire in cross-sectional view
- (7): intermediate layer
- (8): copper wire
- (9): wire precursor
- (10): electric device
- (11): element
- (12): electronic device
- (13): controlled device
- (14): control unit
- (15): surface of copper core
- (16): propelled device
- (17): pull hook
- (18): direction of pulling the pull hook
- (19): angle between wire and surface
- (20): substrate
- (21): bond between wire and substrate
- (22): angle of wire under pull hook pulling the wire
- (23): centre of wire
- (L): Line

## Claims

1. A process for manufacturing a wire (1) comprising at least the following steps:
a. providing a wire precursor (9) comprising a copper core (2) with a surface (15) and a coating layer (3), which coating layer is superimposed over the surface (15) of the copper core (2), wherein the coating layer (3) comprises aluminium,
wherein in a cross-sectional view of the wire precursor (9) the area share of the coating layer (3) is in the range of from 20 to 50 %, based on the total area of the cross-section of the wire precursor (9), and
wherein the aspect ratio between the longest path (5) and the shortest path (6) through the wire precursor (9) in a cross-sectional view is in the range of from larger than 0.8 to 1.0,
wherein the wire precursor (9) has a diameter in the range of from 0.5 to 5 mm.
b. shaping the wire precursor (9),
c. annealing the shaped wire precursor (9),
whereby the wire (1) is obtained,
wherein the wire (1) has a diameter in the range of from 100 µm to 600 µm,
wherein the annealing is performed at a temperature in the range of from 140 °C to 400 °C over a period of from 30 minutes to 5 hours,
wherein an intermediate layer (7) is formed in step c.

## Patentansprüche

1. Ein Verfahren zur Herstellung eines Drahtes (1), das mindestens die folgenden Schritte umfasst:
a. Bereitstellen eines Drahtvorläufers (9), der einen Kupferkern (2) mit einer Oberfläche (15) und einer Überzugsschicht (3) umfasst, wobei die Überzugsschicht über die Oberfläche (15) des Kupferkerns (2) gelegt ist, wobei die Überzugsschicht (3) Aluminium umfasst,
wobei in einer Querschnittsansicht des Drahtvorläufers (9) der Flächenanteil der Überzugsschicht (3) im Bereich von 20 bis 50 % liegt, bezogen auf die Gesamtfläche des Querschnitts des Drahtvorläufers (9), und
wobei das Seitenverhältnis zwischen dem längsten Weg (5) und dem kürzesten Weg (6) durch den Drahtvorläufer (9) in einer Querschnittsansicht im Bereich von größer als 0,8 bis 1,0 liegt,
wobei der Drahtvorläufer (9) einen Durchmesser im Bereich von 0,5 bis 5 mm hat.
b. Formgebung des Drahtvorläufers (9),
c. Glühen des geformten Drahtvorläufers (9),
wodurch der Draht (1) erhalten wird,
wobei der Draht (1) einen Durchmesser im Bereich von 100 µm bis 600 µm hat,
wobei das Glühen bei einer Temperatur im Bereich von 140 °C bis 400 °C über einen Zeitraum von 30 Minuten bis 5 Stunden durchgeführt wird,
wobei in Schritt c eine Zwischenschicht (7) gebildet wird.

## Revendications

1. Un procédé de fabrication d'un fil (1) comprenant au moins les étapes suivantes :
a. fournir un précurseur de fil (9) comprenant une âme en cuivre (2) avec une surface (15) et une couche de revêtement (3), laquelle couche de revêtement est superposée sur la surface (15) de l'âme en cuivre (2), dans lequel la couche de revêtement (3) comprend de l'aluminium,
dans lequel, dans une vue en coupe transversale du précurseur de fil (9), la part de surface de la couche de revêtement (3) est comprise entre 20 et 50 %, sur la base de la surface totale de la section transversale du précurseur de fil (9), et
dans lequel le rapport d'aspect entre le chemin le plus long (5) et le chemin le plus court (6) à travers le précurseur de fil (9) dans une vue en coupe transversale est dans la gamme de plus de 0,8 à 1,0,
où le précurseur de fil (9) a un diamètre compris entre 0,5 et 5 mm.
b. la mise en forme du précurseur du fil (9),
c. le recuit du précurseur de fil formé (9),
par lequel le fil (1) est obtenu,
où le fil (1) a un diamètre compris entre 100 µm et 600 µm,
où le recuit est effectué à une température comprise entre 140 °C et 400 °C sur une période de 30 minutes à 5 heures,
où une couche intermédiaire (7) est formée à l'étape c.
